# EUROPEAN PATENT APPLICATION

(11) **EP 3 067 950 A1**
(43) Date of publication of application: **14.09.2016**
(21) Application number: 14860507.4
(22) Date of filing: 04.11.2014
(51) Int. Cl.: H01L 51/44, H01L 21/368, H01L 51/48

(54) **COATING MATERIAL FOR FORMING SEMICONDUCTORS, SEMICONDUCTOR THIN FILM, THIN FILM SOLAR CELL AND METHOD FOR MANUFACTURING THIN FILM SOLAR CELL**

(30) Priority: 07.11.2013 JP 2013231397; 16.05.2014 JP 2014102142
(71) Applicant: Sekisui Chemical Co., Ltd., Osaka-shi, Osaka 530-0047 (JP)
(72) Inventor: HAYAKAWA Akinobu, Mishima-gun Osaka 618-0021 (JP); OHARA Shunji, Mishima-gun Osaka 618-0021 (JP); HORIKI Mayumi, Mishima-gun Osaka 618-0021 (JP); ITO Kazushi, Mishima-gun Osaka 618-0021 (JP)
(74) Representative: Hart-Davis, Jason
(86) International application number: PCT/JP2014/079206
(87) International publication number: WO 2015/068683

(57) **Abstract**

The present invention aims to provide a coating liquid for forming a semiconductor which facilitates large-area production of a semiconductor that is useful as a semiconductor material of a solar cell with high conversion efficiency and small variation in the conversion efficiency, and enables control of the film thickness. The present invention also aims to provide a semiconductor thin film produced from the coating liquid for forming a semiconductor, a thin film solar cell, and a method for producing the thin film solar cell. The present invention relates to a coating liquid for forming a semiconductor, including a complex that includes a group 15 metal element of the periodic table and sulfur and/or selenium, the coating liquid having a molar ratio of the group 15 metal element of the periodic table to the sulfur and/or selenium of 1:2 to 1:10.

## Description

### TECHNICAL FIELD

The present invention relates to a coating liquid for forming a semiconductor which is suitably used as a semiconductor material for a photoelectric conversion element such as a solar cell. The present invention also relates to a semiconductor thin film produced from the coating liquid for forming a semiconductor, a thin film solar cell, and a method for producing a thin film solar cell.

### BACKGROUND ART

Sulfide or selenide semiconductors such as antimony sulfide (Sb₂S₃), bismuth sulfide (Bi₂S₃), and antimony selenide (Sb₂Se₃) exhibit high light absorption properties in the visible light region because they have a band gap of 1.0 to 2.5 eV, and therefore show promise as a photoelectric conversion material of solar cells or a visible light responsive photocatalyst material. The sulfide or selenide semiconductors have been eagerly studied for use in infrared radiation sensors because of their high light transmission in the infrared region. Additionally, they have drawn attention as a photoconductive material as they exhibit changes in the electric conductivity upon irradiation with light.

Thin films of such a sulfide or selenide semiconductor have been produced by a method such as a vacuum evaporation method, a sputtering method, a chemical vapor deposition (CVD) method or the like. Non-Patent Literature 1, for example, discloses a method for producing an antimony sulfide thin film by a sputtering method. In such a method, a film right after the formation is amorphous (band gap of 2.24 eV), and a crystalline film (band gap of 1. 73 eV) can be obtained by burning at 400°C in a sulfur atmosphere.

Non-Patent Literature 2 discloses a method for producing a sulfide thin film by an electrochemical deposition method. In such a method, films having a band gap of 1.58 eV (Sb₂S₃) and 1.74 eV (Bi₂S₃) can be obtained.

Such methods as a vacuum evaporation method or a sputtering method, however, need expensive apparatus, leading to cost disadvantages. In addition, these methods are difficult to use for forming large-area films. The electrochemical deposition method, which requires no vacuum equipment and allows film formation at normal temperature, needs to include a washing step after the film formation and hardly enables control of the film thickness as desired.

### CITATION LIST

### - Non-Patent Literature

Non-Patent Literature 1: Matthieu Y. Versavel and Joel A. Haber, Thin Solid Films, 515(18), 7171-7176 (2007)
Non-Patent Literature 2: N. S. Yesugade, et al., Thin Solid Films, 263(2), 145-149 (1995)

### SUMMARY OF INVENTION

### - Technical Problem

The present invention aims to, in consideration of the state of the art, provide a coating liquid for forming a semiconductor which facilitates large-area production of a semiconductor that is useful as a semiconductor material of a solar cell with high conversion efficiency and small variation in the conversion efficiency, and enables control of the film thickness. The present invention also aims to provide a semiconductor thin film produced from the coating liquid for forming a semiconductor, a thin film solar cell, and a method for producing the thin film solar cell.

### - Solution to problem

The present invention relates to a coating liquid for forming a semiconductor including a complex that includes a group 15 metal element of the periodic table and sulfur and/or selenium, the coating liquid for forming a semiconductor having a molar ratio of the group 15 metal element of the periodic table to the sulfur and/or selenium of 1:2 to 1:10.

The present invention is specifically described in the following.

The present inventors considered that the use of a coating liquid for forming a semiconductor which contains a metal-containing compound and a sulfur-containing compound and/or a selenium-containing compound enables employment of an application method such as a printing method and facilitates large-area production of a semiconductor including a metal element and sulfur and/or selenium. However, some combinations of a metal-containing compound, a sulfur-containing compound and/or a selenium-containing compound, and a solvent for dissolving these compounds tend to cause the semiconductor film to have a roughened surface or a non-uniform thickness, possibly lowering electrical properties and semiconductor properties. In addition, highly reproducible formation of films is difficult with such a method.

The present inventors studied intensively to find out that, in a coating liquid for forming a semiconductor which includes a metal-containing compound, a sulfur-containing compound and/or a selenium-containing compound, the use of a combination of a metal-containing compound and a sulfur-containing compound and/or a selenium-containing compound which can form a complex including a metal element and sulfur and/or selenium in an organic solvent provides a stable coating liquid, and enables control of the film thickness as desired and production of an intended semiconductor by simple treatment after application. The present inventors have also found out that, by fixing the mixing ratio of a metal element and sulfur and/or selenium to a specific range, the conversion efficiency of a solar cell produced using the coating liquid for forming a semiconductor can be significantly improved and variation in the conversion efficiency can be reduced. Thus, the present invention was completed.

The coating liquid for forming a semiconductor of the present invention contains a complex that includes a group 15 metal element of the periodic table and sulfur and/or selenium at a specific mixing ratio.

Formation of such a complex enables preparation of a stable coating liquid and control of the film thickness as desired. As a result, a uniform, high-quality semiconductor is formed, and moreover, electrical properties and semiconductor properties thereof are improved. The formation of a complex that includes a group 15 metal element of the periodic table and sulfur and/or selenium can be confirmed by measuring an absorption peak due to a bond between the metal element and sulfur or a bond between the metal element and selenium by infrared absorption spectrometry. It can also be confirmed by a change in the color of the solution.

The molar ratio of the group 15 metal element of the periodic table to the sulfur and/or selenium is 1:2 to 1:10. The molar ratio is preferably 1:2.5 to 1:6.

The stoichiometric formula of the semiconductor including the group 15 metal element of the periodic table and the sulfur and/or selenium is X₂Y₃ wherein X represents the group 15 metal element of the periodic table and Y represents the sulfur and/or selenium. The stoichiometric ratio (molar ratio) of the group 15 metal element of the periodic table to the sulfur and/or selenium is therefore 1:1.5.

In the coating liquid for forming a semiconductor of the present invention, the molar ratio of the group 15 metal element of the periodic table to the sulfur and/or selenium is fixed to the above range such that the value of the sulfur and/or selenium in the molar ratio is greater than that of the stoichiometric ratio. This significantly improves the conversion efficiency of the solar cell produced using the coating liquid for forming a semiconductor of the present invention. Moreover, variation in the conversion efficiency can be reduced. The reason for this is not clear, but is presumably as follows. In the coating liquid for forming a semiconductor, the complex that includes a group 15 metal element of the periodic table and sulfur and/or selenium is in equilibrium with the metal-containing compound and the sulfur-containing compound and/or the selenium-containing compound before formation of the complex. Excessive addition of the sulfur-containing compound and/or the selenium-containing compound shifts the equilibrium toward formation of a complex, and thus the complex that includes a group 15 metal element of the periodic table and sulfur and/or selenium is stably formed.

The group 15 metal element of the periodic table is preferably antimony or bismuth. More preferred is antimony because a semiconductor formed has better electrical properties and semiconductor properties.

The complex that includes a group 15 metal element of the periodic table and sulfur and/or selenium is preferably formed between the group 15 metal element of the periodic table and the sulfur-containing compound and/or the selenium-containing compound. The sulfur element in the sulfur-containing compound and the selenium element in the selenium-containing compound have a lone pair of electrons not involved in chemical bonds. These elements thus easily form a coordination bond between an empty electron orbital (d or f orbital) and them.

For formation of such a complex, the coating liquid for forming a semiconductor of the present invention is preferably prepared from components including at least a metal-containing compound containing a group 15 metal element of the periodic table, a sulfur-containing compound and/or a selenium-containing compound, and an organic solvent.

The metal-containing compound containing a group 15 element of the periodic table is not limited as long as it can form a complex together with an appropriate combination of a sulfur-containing compound and/or a selenium-containing compound and an organic solvent to be used. Examples of the metal-containing compound containing a group 15 metal element of the periodic table include metal salts and organometallic compounds of the group 15 metal elements of the periodic table.

Examples of the metal salts of group 15 metal elements of the periodic table include chlorides, oxychlorides, nitrates, carbonates, sulfates, ammonium salts, borates, silicates, phosphates, hydroxides, and peroxides of group 15 metal elements of the periodic table. The metal salts of group 15 metal elements of the periodic table include hydrates thereof.

Examples of the organometallic compounds of group 15 elements of the periodic table include salt compounds of group 15 metal elements of the periodic table with carboxylic acids, dicarboxylic acids, oligocarboxylic acids, or polycarboxylic acids. Specific examples thereof include salt compounds of group 15 metal elements of the periodic table with acetic acid, formic acid, propionic acid, octylic acid, stearic acid, oxalic acid, citric acid, or lactic acid.

Specific examples of the metal-containing compound containing a group 15 metal element of the periodic table include antimony chloride, antimony acetate, antimony bromide, antimony fluoride, antimony oxyoxide, triethoxyantimony, tripropoxyantimony, bismuth nitrate, bismuth chloride, bismuth hydroxide nitrate, tris(2-methoxyphenyl)bismuth, bismuth carbonate, basic bismuth carbonate, bismuth phosphate, bismuth bromide, triethoxybismuth, triisopropoxyantimony, arsenic iodide, and arsenic triethoxide. These compounds containing a group 15 metal element of the periodic table may be used alone, or in combination of two or more thereof.

Regarding the amount of the metal-containing compound containing a group 15 metal element of the periodic table in the coating liquid for forming a semiconductor of the present invention, the lower limit is preferably 3% by weight, whereas the upper limit is preferably 30% by weight. The lower limit is more preferably 5% by weight, and the upper limit is more preferably 20% by weight. The lower limit is still more preferably 7% by weight, and the upper limit thereof is still more preferably 15% by weight. If the amount is 3% by weight or more, a high-quality semiconductor can be easily formed. If the amount is 30% by weight or less, a stable coating liquid for forming a semiconductor can be easily prepared.

The sulfur-containing compound and/or the selenium-containing compound are/is not limited as long as it can form a complex together with an appropriate combination of a group 15 metal element of the periodic table and an organic solvent to be used.

Examples of the sulfur-containing compound include thiourea, derivatives of thiourea, dithiocarbamates, xanthates, dithiophosphates, thiosulfates, thiocyanates, thioacetamide, and dithiobiuret.

Examples of the selenium-containing compound include selenium chloride, selenium bromide, selenium iodide, selenophenol, selenourea, derivatives of selenourea, selenious acid, selenoacetamide, derivatives of selenoacetamide, diselenocarbamates, selenosulfates, selenocyanates, and hydrogen selenide.

Examples of the derivatives of thiourea include 1-acetyl-2-thiourea, ethylenethiourea, 1,3-diethyl-2-thiourea, 1,3-dimethylthiourea, tetramethylthiourea, N-methylthiourea, and 1-phenyl-2-thiourea. Examples of the dithiocarbamates include sodium dimethyldithiocarbamate, sodium diethyldithiocarbamate, potassium dimethyldithiocarbamate, and potassium diethyldithiocarbamate. Examples of the xanthates include sodium ethylxanthate, potassium ethylxanthate, sodium isopropylxanthate, and potassium isopropylxanthate. Examples of the thiosulfates include sodium thiosulfate, potassium thiosulfate, and ammonium thiosulfate. Examples of the thiocyanates include sodium thiocyanate, potassium thiocyanate, and ammonium thiocyanate. These sulfur-containing compounds may be used alone, or in combination of two or more thereof.

Examples of the derivatives of selenourea include 1-acetyl-2-selenourea, ethyleneselenourea, 1,3-diethyl-2-selenourea, 1,3-dimethylselenourea, tetramethylselenourea, N-methylselenourea, and 1-phenyl-2-selenourea. Examples of the diselenocarbamates include sodium dimethyldiselenocarbamate, sodium diethyldiselenocarbamate, potassium dimethyldiselenocarbamate, and potassium diethyldiselenocarbamate. Examples of the selenosulfate include sodium selenosulfate, potassium selenosulfate, and ammonium selenosulfate. Examples of the selenocyanates include potassium selenocyanate and ammonium selenocyanate. These selenium-containing compounds may be used alone, or in combination of two or more thereof.

The organic solvent is not limited as long as it can form a complex together with an appropriate combination of a metal-containing compound containing a group 15 metal element of the periodic table and a sulfur-containing compound and/or a selenium-containing compound to be used.

Examples of the organic solvent include methanol, ethanol, N,N-dimethylformamide, dimethyl sulfoxide, acetone, dioxane, tetrahydrofuran, isopropanol, n-propanol, chloroform, chlorobenzene, and pyridine. Preferred among these are methanol, ethanol, and acetone. These organic solvents may be used alone, or in combination of two or more thereof. N,N-dimethylformamide is preferred as it contributes to the formation of a semiconductor with even better electrical properties and semiconductor properties.

The coating liquid for forming a semiconductor of the present invention may further contain a non-organic solvent component such as water to the extent that it does not impair the effects of the present invention.

Specific examples of the complex that includes the group 15 metal element of the periodic table and sulfur include a bismuth-thiourea complex, a bismuth-thiosulfuric acid complex, a bismuth-thiocyanic acid complex, an antimony-thiourea complex, an antimony-thiosulfuric acid complex, an antimony-thiocyanic acid complex, an antimony-dithiocarbamic acid complex, and an antimony-xanthogenic acid complex.

Specific examples of the complex include the group 15 metal element of the periodic table and selenium include a bismuth-selenourea complex, a bismuth-selenocyanic acid complex, a bismuth-dimethylselenourea complex, an antimony-selenourea complex, an antimony-selenocyanic acid complex, and an antimony-dimethylselenourea complex.

The present invention also encompasses a semiconductor thin film produced by applying the coating liquid for forming a semiconductor of the present invention to a substrate. A thin film of a semiconductor prepared as above is useful as a solar cell material, a photocatalyst material, or a photoconductive material.

The method of applying the coating liquid for forming a semiconductor of the present invention is not limited, and examples thereof include a printing method such as a spin coating method or a roll-to-roll method. The use of the coating liquid for forming a semiconductor of the present invention allows employment of an application method such as a printing method, which enables formation of a uniform and smooth semiconductor thin film and control of the film thickness as desired. This improves electrical properties and semiconductor properties of the semiconductor thin film and also reduces the formation costs.

The present invention also encompasses a thin film solar cell using a semiconductor produced from the coating liquid for forming a semiconductor of the present invention as a photoelectric conversion layer.

The photoelectric conversion layer preferably includes an organic semiconductor adjacent to the semiconductor produced from the coating liquid for forming a semiconductor of the present invention. In this case, regarding the positional relationship between the semiconductor produced from the coating liquid for forming a semiconductor of the present invention and the organic semiconductor in the photoelectric conversion layer, they are adjacent to each other. The photoelectric conversion layer may be a laminate including a semiconductor thin film produced from the coating liquid for forming a semiconductor of the present invention and an organic semiconductor thin film, or a composite film including a composite of a semiconductor produced from the coating liquid for forming a semiconductor of the present invention and an organic semiconductor.

When the photoelectric conversion layer is a laminate including a semiconductor thin film produced from the coating liquid for forming a semiconductor of the present invention and an organic semiconductor thin film, the lower limit of the thickness of the semiconductor thin film produced from the coating liquid for forming a semiconductor of the present invention is preferably 5 nm, whereas the upper limit thereof is preferably 5000 nm. When the thickness is 5 nm or more, the photoelectric conversion layer can sufficiently absorb light, thus further improving the conversion efficiency of the thin film solar cell. When the thickness is 5000 nm or less, the generation of regions where charge separation does not occur can be suppressed in the photoelectric conversion layer, thus improving the conversion efficiency of the thin film solar cell. The lower limit of the thickness is more preferably 10 nm, and the upper limit is more preferably 1000 nm. The lower limit is still more preferably 20 nm, and the upper limit is still more preferably 500 nm.

The lower limit of the thickness of the organic semiconductor thin film is preferably 5 nm, whereas the upper limit is preferably 1000 nm. When the thickness is 5 nm or more, the photoelectric conversion layer can sufficiently absorb light, thus further improving the conversion efficiency of the thin film solar cell. When the thickness is 1000 nm or less, the generation of regions where charge separation does not occur can be suppressed in the photoelectric conversion layer, thus improving the conversion efficiency of the thin film solar cell. The lower limit of the thickness is more preferably 10 nm, and the upper limit is more preferably 500 nm. The lower limit is still more preferably 20 nm, and the upper limit is still more preferably 200 nm.

When the photoelectric conversion layer is a composite film including a composite of a semiconductor produced from the coating liquid for forming a semiconductor of the present invention and an organic semiconductor, the lower limit of the thickness of the composite film is preferably 30 nm, whereas the upper limit thereof is preferably 3000 nm. When the thickness is 30 nm or more, the photoelectric conversion layer can sufficiently absorb light, thus further improving the conversion efficiency of the thin film solar cell. When the thickness is 3000 nm or less, the electrical charge can easily reach the electrodes, thus improving the conversion efficiency of the thin film solar cell. The lower limit of the thickness is more preferably 40 nm, and the upper limit thereof is more preferably 1000 nm. The lower limit is still more preferably 50 nm, and the upper limit is still more preferably 500 nm.

A laminate including a semiconductor thin film produced from the coating liquid for forming a semiconductor of the present invention and an organic semiconductor thin film may be produced by a method including the steps of applying the coating liquid for forming a semiconductor of the present invention to a substrate or another layer to form a semiconductor thin film, and laminating an organic semiconductor thin film on the semiconductor thin film. Alternatively, the method may include the steps of laminating an organic semiconductor thin film on a substrate or another layer first, and applying the coating liquid for forming a semiconductor of the present invention to the organic semiconductor thin film to form a semiconductor thin film.

A composite film including a composite of a semiconductor produced from the coating liquid for forming a semiconductor of the present invention and an organic semiconductor may be produced by a method including the steps of applying a mixed liquid of the coating liquid for forming a semiconductor of the present invention and an organic semiconductor to a substrate or another layer.

The present invention also encompasses a method for producing a thin film solar cell which includes these steps.

The organic semiconductor is not limited, and examples thereof include thiophene derivatives such as poly(3-alkylthiophene). Examples of the organic semiconductor include conductive polymers such as polyparaphenylene vinylene derivatives, polyvinyl carbazole derivatives, polyaniline derivatives, polyacetylene derivatives, or polytriphenylamine. Examples of the organic semiconductor also include phthalocyanine derivatives, naphthalocyanine derivatives, pentacene derivatives, porphyrin derivatives such as benzoporphyrin derivatives, and triphenylamine derivatives. Preferred among these are thiophene derivatives, phthalocyanine derivatives, naphthalocyanine derivatives, benzoporphyrin derivatives, and triphenylamine derivatives because they have relatively high durability.

The thin film solar cell of the present invention may further include, in addition to the photoelectric conversion layer, a substrate, a hole transport layer, an electron transport layer, or other components. The substrate is not limited, and may be, for example, a transparent glass substrate such as a soda-lime glass or alkali-free glass substrate, a ceramic substrate, or a transparent plastic substrate.

The materials of the hole transport layer are not limited. Examples of the materials include P-type conductive polymers, P-type low molecular weight organic semiconductors, P-type metal oxides, P-type metal sulfides, and surfactants. Specific examples thereof include polystyrene sulfonate-doped polyethylene dioxythiophene, carboxyl group-containing polythiophene, phthalocyanine, porphyrin, fluoro group-containing phosphonic acid, carbonyl group-containing phosphonic acid, molybdenum oxide, vanadium oxide, tungsten oxide, nickel oxide, copper oxide, tin oxide, molybdenum sulfide, tungsten sulfide, copper sulfide, and tin sulfide.

The materials of the electron transport layer are not limited. Examples of the materials include N-type conductive polymers, N-type low molecular weight organic semiconductors, N-type metal oxides, N-type metal sulfides, alkali metal halides, alkali metals, and surfactants. Specific examples thereof include cyano group-containing polyphenylene vinylene, boron-containing polymers, bathocuproine, bathophenanthroline, hydroxy quinolinato aluminum, oxadiazol compounds, benzoimidazole compounds, naphthalene tetracarboxylic acid compounds, perylene derivatives, phosphine oxide compounds, phosphine sulfide compounds, fluoro group-containing phthalocyanine, titanium oxide, zinc oxide, indium oxide, tin oxide, gallium oxide, tin sulfide, indium sulfide, and zinc sulfide.

### - Advantageous Effects of Invention

The present invention can provide a coating liquid for forming a semiconductor which facilitates large-area production of a semiconductor that is useful as a semiconductor material of a solar cell with high conversion efficiency and small variation in the conversion efficiency and enables control of the film thickness. The present invention can also provide a semiconductor thin film produced from the coating liquid for forming a semiconductor, a thin film solar cell, and a method for producing the thin film solar cell.

### DESCRIPTION OF EMBODIMENTS

The following will describe the present invention in more detail with reference to examples. The present invention should not be limited to these examples.

### (Example 1)

### (Preparation of coating liquid for forming semiconductor)

An amount of 20 parts by weight of antimony (III) chloride was added to 100 parts by weight of N,N-dimethylformamide. The mixture was then stirred to give an antimony(III) chloride solution. Separately, 20 parts by weight of thiourea (CS(NH₂)₂) was added to 100 parts by weight of N,N-dimethylformamide. The mixture was then stirred to give a thiourea (CS(NH₂)₂) solution. An amount of 1 mL of the obtained thiourea (CS(NH₂)₂) solution was gradually added to 1 mL of the obtained antimony(III) chloride solution with stirring. During the addition, the solution, which was clear colorless before mixing, turned into clear yellow. After the addition was completed, the mixed solution was stirred for another 30 minutes. Thus, a coating liquid for forming a semiconductor was prepared. The obtained coating liquid for forming a semiconductor had a molar ratio Sb:S of 1:3.

According to the infrared absorption spectrometry performed on the coating liquid for forming a semiconductor, positions (3370 cm⁻¹, 3290 cm⁻¹, 3148 cm⁻¹) of three absorption peaks due to -NH₂ stretching vibration were the same as the positions of the absorption peaks derived from -NH₂ of thiourea alone. Regarding the absorption peak due to a C=S bond, a single peak (1413 cm⁻¹) was observed in the case of thiourea alone, and two peaks were observed in the case of the coating liquid for forming a semiconductor. The absorption peak due to C-N stretching vibration was shifted from 1474 cm⁻¹ to 1511 cm⁻¹.

These results shows that a complex was formed between antimony and thiourea in the coating liquid for forming a semiconductor, and the complex was formed not between an antimony atom and a nitrogen atom in thiourea but between an antimony atom and a sulfur atom in thiourea.

### (Formation of semiconductor thin film)

The coating liquid for forming a semiconductor was applied to an ITO glass substrate (thickness of ITO film: 240 nm) at 1000 rpm by a spin coating method. The film after the application was almost clear colorless. Then, the sample was put in a vacuum furnace and burnt at 260°C for 10 minutes while drawing a vacuum, whereby an antimony sulfide thin film was obtained. The film taken out of the vacuum furnace was black.

The average film thickness of the obtained film measured with a film thickness meter (available from KLA-TENCOR Japan, P-16+) was 100 nm. The absorption spectrum of the film was obtained using a spectrophotometer (available from Hitachi High-Technologies Corporation., U-4100), and the band gap estimated based on the absorption spectrum was 1.70 eV. The thin film X-ray diffraction analysis (device: RINT-Ultima III) revealed that the obtained film was a crystalline film having a stibnite structure. In addition, the film surface observed with an optical microscope and a laser microscope was smooth and uniform.

### (Preparation of thin film solar cell)

To the surface of a FTO film, a 2% solution of titanium isopropoxide in ethanol was applied by a spin coating method and burnt at 400°C for 10 minutes, whereby an electron transporting buffer layer was formed. In addition, a paste of titanium oxide (mixture of those having an average particle size of 10 nm and 30 nm) containing polyisobutyl methacrylate as an organic binder was laminated thereon by a spin coating method, and burnt at 400°C for 10 minutes, whereby a porous film having a thickness of 400 nm was obtained.

Next, the coating liquid for forming a semiconductor obtained above was applied thereto at 1000 rpm by a spin coating method. The film after the application was almost clear colorless. The sample was put in a vacuum furnace and burnt at 260°C for 10 minutes while drawing a vacuum, whereby an antimony sulfide thin film was obtained (film thickness : 100 nm) . On the surface of the obtained antimony sulfide thin film, a film (thickness: 30 nm) of poly(3-hexylthiophene) (P3HT) was formed as a P-type semiconductor layer by a spin coating method.

Thereafter, a film of poly(3,4-ethylene dioxythiophene):poly(styrene sulfonate) (PEDOT:PSS) with a thickness of 100 nm as a hole transport layer was formed. Then, a gold electrode with a thickness of 80 nm was formed on the hole transport layer by a vacuum evaporation method. Thus, a thin film solar cell was prepared.

### (Example 2)

A coating liquid for forming a semiconductor, a semiconductor thin film, and a thin film solar cell were prepared in the same manner as in Example 1, except that antimony(III) chloride was changed to antimony(III) acetate. The formation of a complex in the coating liquid for forming a semiconductor and physical properties of the semiconductor thin film were evaluated in the same manner as in Example 1.

### (Example 3)

A coating liquid for forming a semiconductor, a semiconductor thin film, and a thin film solar cell were prepared in the same manner as in Example 1, except that the amount of the thiourea solution was changed to 0.7 mL to set the molar ratio Sb:S to 1:2.1. The formation of a complex in the coating liquid for forming a semiconductor and physical properties of the semiconductor thin film were evaluated in the same manner as in Example 1.

### (Example 4)

A coating liquid for forming a semiconductor, a semiconductor thin film, and a thin film solar cell were prepared in the same manner as in Example 1, except that the amount of the thiourea solution was changed to 0.8 mL to set the molar ratio Sb:S to 1:2.4. The formation of a complex in the coating liquid for forming a semiconductor and physical properties of the semiconductor thin film were evaluated in the same manner as in Example 1.

### (Example 5)

A coating liquid for forming a semiconductor, a semiconductor thin film, and a thin film solar cell were prepared in the same manner as in Example 1, except that the amount of the thiourea solution was changed to 1.5 mL to set the molar ratio Sb:S to 1:4.5. The formation of a complex in the coating liquid for forming a semiconductor and physical properties of the semiconductor thin film were evaluated in the same manner as in Example 1.

### (Example 6)

A coating liquid for forming a semiconductor, a semiconductor thin film, and a thin film solar cell were prepared in the same manner as in Example 1, except that the amount of the thiourea solution was changed to 2.0 mL to set the molar ratio Sb: S to 1: 6. The formation of a complex in the coating liquid for forming a semiconductor and physical properties of the semiconductor thin film were evaluated in the same manner as in Example 1.

### (Example 7)

A coating liquid for forming a semiconductor, a semiconductor thin film, and a thin film solar cell were prepared in the same manner as in Example 1, except that the amount of the thiourea solution was changed to 2.1 mL to set the molar ratio Sb:S to 1:6.3. The formation of a complex in the coating liquid for forming a semiconductor and physical properties of the semiconductor thin film were evaluated in the same manner as in Example 1.

### (Example 8)

A coating liquid for forming a semiconductor, a semiconductor thin film, and a thin film solar cell were prepared in the same manner as in Example 1, except that the amount of the thiourea solution was changed to 3.0 mL to set the molar ratio Sb: S to 1: 9. The formation of a complex in the coating liquid for forming a semiconductor and physical properties of the semiconductor thin film were evaluated in the same manner as in Example 1.

### (Example 9)

A coating liquid for forming a semiconductor, a semiconductor thin film, and a thin film solar cell were prepared in the same manner as in Example 1, except that thiourea was changed to thioacetamide and the amount of thioacetamide was determined to set the molar ratio Sb: S to 1: 3. The physical properties of the semiconductor thin film were evaluated in the same manner as in Example 1. In addition, formation of a complex between antimony and thioacetamide was confirmed.

### (Example 10)

A coating liquid for forming a semiconductor, a semiconductor thin film, and a thin film solar cell were prepared in the same manner as in Example 1, except that thiourea was changed to dithiobiuret and the amount of dithiobiuret was determined to set the molar ratio Sb:S to 1:3. The physical properties of the semiconductor thin film were evaluated in the same manner as in Example 1. In addition, formation of a complex between antimony and dithiobiuret was confirmed.

### (Example 11)

A coating liquid for forming a semiconductor, a semiconductor thin film, and a thin film solar cell were prepared in the same manner as in Example 1, except that thiourea was changed to 1,3-dimethylthiourea and the amount of 1, 3-dimethylthiourea was determined to set the molar ratio Sb: S to 1:3. The physical properties of the semiconductor thin film were evaluated in the same manner as in Example 1. In addition, formation of a complex between antimony and 1,3-dimethylthiourea was confirmed.

### (Example 12)

A coating liquid for forming a semiconductor, a semiconductor thin film, and a thin film solar cell were prepared in the same manner as in Example 1, except that N,N-dimethylformamide was changed to methanol. The formation of a complex in the coating liquid for forming a semiconductor and physical properties of the semiconductor thin film were evaluated in the same manner as in Example 1.

### (Example 13)

### (Preparation of coating liquid for forming semiconductor)

An amount of 20 parts by weight of antimony (III) chloride was added to 100 parts by weight of N, N-dimethylformamide. The mixture was then stirred to give an antimony(III) chloride solution. Separately, 32 parts by weight of selenourea (CSe(NH₂)₂) was added to 100 parts by weight of N,N-dimethylformamide. The mixture was then stirred to give a selenourea (CSe(NH₂)₂) solution. An amount of 1 mL of the obtained selenourea (CSe(NH₂)₂) solution was gradually added to 1 mL of the obtained antimony(III) chloride solution with stirring. During the addition, the solution, which was clear colorless before mixing, turned into clear yellow. After the addition was completed, the mixed solution was stirred for another 30 minutes. Thus, a coating liquid for forming a semiconductor was prepared. The obtained coating liquid for forming a semiconductor had a molar ratio Sb:Se of 1:3. The formation of a complex between antimony and selenourea was confirmed by infrared absorption spectrometry in the same manner as described above.

### (Formation of semiconductor thin film)

The coating liquid for forming a semiconductor was applied to an ITO glass substrate (thickness of ITO film: 240 nm) at 1000 rpm by a spin coating method. The film after the application was almost clear colorless. The sample was put in a vacuum furnace and burnt at 260°C for 10 minutes while drawing a vacuum, whereby an antimony selenide thin film was obtained. The film taken out of the vacuum furnace was black.

The average film thickness of the obtained film measured with a film thickness meter (available from KLA-TENCOR Japan, P-16+) was 120 nm. The absorption spectrum of the film was obtained using a spectrophotometer (available from Hitachi High-Technologies Corporation., U-4100), and the band gap estimated based on the absorption spectrum was 1.30 eV. The thin film X-ray diffraction analysis (device: RINT-Ultima III) revealed that the obtained film was a crystalline film including antimony selenide. In addition, the film surface observed with an optical microscope and a laser microscope was smooth and uniform.

### (Preparation of a thin film solar cell)

To the surface of a FTO film, a 2% solution of titanium isopropoxide in ethanol was applied by a spin coating method and burnt at 400°C for 10 minutes, whereby an electron-transporting buffer layer was formed. In addition, a paste of titanium oxide (mixture of those having an average particle size of 10 nm and 30 nm) containing polyisobutyl methacrylate as an organic binder was laminated thereon by a spin coating method, and burnt at 400°C for 10 minutes, whereby a porous film having a thickness of 400 nm was obtained.

Next, the coating liquid for forming a semiconductor obtained above was applied thereto at 1000 rpm by a spin coating method. The film after the application was almost clear colorless. The sample was put in a vacuum furnace and burnt at 260°C for 10 minutes while drawing a vacuum, whereby an antimony selenide thin film was obtained (film thickness : 120 nm) . On the surface of the obtained antimony selenide thin film, a film (thickness: 30 nm) of poly(3-hexylthiophene) (P3HT) was formed as a P-type semiconductor layer by a spin coating method.

Thereafter, a film of poly(3,4-ethylene dioxythiophene):poly(styrene sulfonate) (PEDOT:PSS) with a thickness of 100 nm as a hole transport layer was formed by a spin coating method. Then, a gold electrode with a thickness of 80 nm was formed on the surface by a vacuum evaporation method. Thus, a thin film solar cell was prepared.

### (Example 14)

A coating liquid for forming a semiconductor, a semiconductor thin film, and a thin film solar cell were prepared in the same manner as in Example 13, except that the amount of the selenourea solution was changed to set the molar ratio Sb: Se to 1:2.1. The formation of a complex in the coating liquid for forming a semiconductor and physical properties of the semiconductor thin film were evaluated in the same manner as in Example 13.

### (Example 15)

A coating liquid for forming a semiconductor, a semiconductor thin film, and a thin film solar cell were prepared in the same manner as in Example 13, except that the amount of the selenourea solution was changed to set the molar ratio Sb: Se to 1:4.5. The formation of a complex in the coating liquid for forming a semiconductor and physical properties of the semiconductor thin film were evaluated in the same manner as in Example 13.

### (Example 16)

A coating liquid for forming a semiconductor, a semiconductor thin film, and a thin film solar cell were prepared in the same manner as in Example 13, except that the amount of the selenourea solution was changed to set the molar ratio Sb:Se to 1:6. The formation of a complex in the coating liquid for forming a semiconductor and physical properties of the semiconductor thin film were evaluated in the same manner as in Example 13.

### (Example 17)

A coating liquid for forming a semiconductor, a semiconductor thin film, and a thin film solar cell were prepared in the same manner as in Example 13, except that selenourea was changed to 1, 3-dimethylselenourea and the amount of 1, 3-dimethylselenourea was determined to set the molar ratio Sb: Se to 1: 3. The physical properties of the semiconductor thin film were evaluated in the same manner as in Example 13. In addition, formation of a complex between antimony and 1,3-dimethylselenourea was confirmed.

### (Comparative Example 1)

A coating liquid for forming a semiconductor, a semiconductor thin film, and a thin film solar cell were prepared in the same manner as in Example 1, except that thiourea was changed to sodium sulfide, the amount of sodium sulfide was determined to set the molar ratio Sb:S to 1:3, and N,N-dimethylformamide was changed to methanol. The physical properties of the semiconductor thin film were evaluated in the same manner as in Example 1.

The obtained coating liquid for forming a semiconductor was not a clear liquid but a yellow cloudy liquid that tends to have precipitation. As a result of the infrared absorption spectrometry and fluorescent X-ray analysis, the yellow cloudy component was found to be antimony sulfide. It was confirmed that, in the case of using sodium sulfide, no complex was formed in the coating liquid for forming a semiconductor and antimony chloride and sodium sulfide reacted with each other directly to form antimony sulfide.

### (Comparative Example 2)

A coating liquid for forming a semiconductor, a semiconductor thin film, and a thin film solar cell were produced in the same manner as in Example 1, except that N,N-dimethylformamide was changed to water. The physical properties of the semiconductor thin film were evaluated in the same manner as in Example 1.

The obtained coating liquid for forming a semiconductor was not a clear liquid but a white cloudy liquid. As a result of the infrared absorption spectrometry and fluorescent X-ray analysis, the white cloudy component was found to be antimony oxide. Formation of such a component was presumably derived from the tendency of antimony chloride as a raw material to hydrolyze in water.

### (Comparative Example 3)

A coating liquid for forming a semiconductor, a semiconductor thin film, and a thin film solar cell were prepared in the same manner as in Example 1, except that the amount of the thiourea solution was changed to 0.6 mL to set the molar ratio Sb:S to 1:1.5. The formation of a complex in the coating liquid for forming a semiconductor and physical properties of the semiconductor thin film were evaluated in the same manner as in Example 1.

### (Comparative Example 4)

A coating liquid for forming a semiconductor, a semiconductor thin film, and a thin film solar cell were prepared in the same manner as in Example 1, except that the amount of the thiourea solution was changed to 4.0 mL to set the molar ratio Sb:S to 1:12. The formation of a complex in the coating liquid for forming a semiconductor and physical properties of the semiconductor thin film were evaluated in the same manner as in Example 1.

### (Comparative Example 5)

A coating liquid for forming a semiconductor, a semiconductor thin film, and a thin film solar cell were prepared in the same manner as in Example 13, except that selenourea was changed to sodium selenide, the amount of sodium selenide was determined to set the molar ratio Sb:Se to 1:3, and N,N-dimethylformamide was changed to methanol. The physical properties of the semiconductor thin film were evaluated in the same manner as in Example 13.

The obtained coating liquid for forming a semiconductor was not a clear liquid but a black cloudy liquid that tends to have precipitation. As a result of the infrared absorption spectrometry and fluorescent X-ray analysis, the black cloudy component was found to be antimony selenide. It was confirmed that, in the case of using sodium selenide, no complex was formed in the coating liquid for forming a semiconductor and antimony chloride and sodium selenide reacted with each other directly to form antimony selenide.

### (Comparative Example 6)

A coating liquid for forming a semiconductor, a semiconductor thin film, and a thin film solar cell were prepared in the same manner as in Example 13, except that N,N-dimethylformamide was changed to water. The physical properties of the semiconductor thin film were evaluated in the same manner as in Example 13.

In the obtained coating liquid for forming a semiconductor, a black precipitate was generated. Formation of such a precipitate was presumably derived from the tendency of selenourea as a raw material to hydrolyze in water.

### (Comparative Example 7)

A coating liquid for forming a semiconductor, a semiconductor thin film, and a thin film solar cell were prepared in the same manner as in Example 13, except that the amount of the selenourea solution was changed to set the molar ratio Sb: Se to 1:1.5. The formation of a complex in the coating liquid for forming a semiconductor and physical properties of the semiconductor thin film were evaluated in the same manner as in Example 13.

### (Comparative Example 8)

A coating liquid for forming a semiconductor, a semiconductor thin film, and a thin film solar cell were prepared in the same manner as in Example 13, except that the amount of selenourea solution was changed to set the molar ratio Sb: Se to 1:12. The formation of a complex in the coating liquid for forming a semiconductor and physical properties of the semiconductor thin film were evaluated in the same manner as in Example 13.

### (Evaluation)

The obtained thin film solar cells were subjected to the evaluations below.

### (Evaluation on properties of solar cell)

A power source (Model 236, available from Keithley Instruments Inc.) was connected between the electrodes of each of the thin film solar cells obtained in the examples and comparative examples. The conversion efficiency of each thin film solar cell was measured using a solar simulator (available from Yamashita Denso Corporation) at an intensity of 100 mW/cm². The conversion efficiencies of the thin film solar cells obtained in Examples 1 to 12 and Comparative Examples 1 to 4 were standardized based on the conversion efficiency of the thin film solar cell obtained in Comparative Example 1 regarded as 1.00. The conversion efficiencies of the thin film solar cells obtained in Examples 13 to 17 and Comparative Examples 5 to 8 were standardized based on the conversion efficiency of the thin film solar cell obtained in Comparative Example 5 regarded as 1.00.

In addition, four thin film solar cells were prepared in the same manner, and variation in the conversion efficiency was evaluated by determining the maximum value/minimum value of the conversion efficiency of the four cells, based on the following criteria.
○○: Maximum value/minimum value was 1 or more but less than 1.5.
○: Maximum value/minimum value was 1.5 or more but less than 2.
×: Maximum value/minimum value was 2 or more. Tables 1 and 2 show the results.

**[Table 1]**

| | **Formulation of coating liquid** | | | | | **Physical properties of film** | | | | **Properties of solar cell** | |
|---|---|---|---|---|---|---|---|---|---|---|---|
| | **Metal-containing compound** | **Sulfur-containing compound** | **Solvent** | **Sb:S molar ratio** | **Formation of complex** | **Average film thickness (nm)** | **Band gap (eV)** | **Crystallinity** | **Film quality (surface state)** | **Relative conversion efficiency (to Comparative Example 1)** | **Variation** |
| Example 1 | SbCl₃ | Thiourea | N.N-dimethylformamide | 1:3 | Antimony - thiourea | 100 | 1.70 | Crystalline | Smooth, uniform | 10.0 | OO |
| Example 2 | Sb(CH₃COO)₃ | Thiourea | N,N-dimethylformamide | 1:3 | Antimony - thiourea | 80 | 1.70 | Crystalline | Smooth, uniform | 7.5 | OO |
| Example 3 | SbCl₃ | Thiourea | N,N-dimethylformamide | 1:2.1 | Antimony - thiourea | 120 | 1.70 | Crystalline | Smooth, uniform | 7.5 | O |
| Examples 4 | SbCl₃ | Thiourea | N,N-dimethylformamide | 1:2.4 | Antimony - thiourea | 110 | 1.70 | Crystalline | Smooth, uniform | 8.5 | O |
| Example 5 | SbCl₃ | Thiourea | N,N-dimethylformamide | 1:4.5 | Antimony - thiourea | 90 | 1.70 | Crystalline | Smooth, uniform | 11.0 | OO |
| Example 6 | SbCl₃ | Thiourea | N,N-dimethylformamide | 1:6 | Antimony - thiourea | 80 | 1.70 | Crystalline | Smooth, uniform | 10.5 | OO |
| Example 7 | SbCl₃ | Thiourea | N.N-dimethylformamide | 1:6.3 | Antimony - thiourea | 80 | 1.70 | Crystalline | Smooth, uniform | 9.0 | O |
| Example 8 | SbCl₃ | Thiourea | N,N-dimethylformamide | 1:9 | Antimony - thiourea | 70 | 1.70 | Crystalline | Smooth, uniform | 7.5 | O |
| Example 9 | SbCl₃ | Thioacetamide | N,N-dimethylformamide | 1:3 | Antimony - thioacetamide | 110 | 1.75 | Crystalline | Smooth, uniform | 7.5 | OO |
| Example 10 | SbCl₃ | Dithiobiuret | N,N-dimethylformamide | 1:3 | Antimony - &th;obairet | 90 | 1.70 | Crystalline | Smooth, uniform | 7.0 | OO |
| Example 11 | SbCl₃ | 1,3-dimethylthiourea | N,N-dimethylformamide | 1:3 | Antimony- 1,3-dimethylthiourea | 100 | 1.70 | Crystalline | Smooth, uniform | 8.5 | OO |
| Example 12 | SbCl₃ | Thioourea | Methanol | 1:3 | Antimony - thiourea | 100 | 1.70 | Crystalline | Smooth, uniform | 8.9 | OO |
| Comparative Example 1 | SbCl₃, | Sodium sulfide | Methanol | 1:3 | None | 105 | 1.70 | Crystalline | Rough. non-uniform | 1.0 | × |
| Comparative Example 2 | SbCl₃ | Thiourea | Water | 1:3 | None | 105 | 1.70 | Crystalline | Rough, non-uniform | 1.5 | × |
| Comparative Example 3 | SbCl₃ | Thiourea | N,N-dimethylformamide | 1:1.5 | Antimony - thiourea | 120 | 1.70 | Crystalline | Smooth, uniform | 3.5 | × |
| Comparative Example 4 | SbCl₃ | Thiourea | N,N-dimethylformamide | 1:12 | Antimony - thiourea | 60 | 1.70 | Crystalline | Smooth, uniform | 3.0 | × |

**[Table 2]**

| | **Formulation of coating liquid** | | | | | **Physical properties of film** | | | | **Properties of solar cell** | |
|---|---|---|---|---|---|---|---|---|---|---|---|
| | **Metal-containing compound** | **Selenium-containing compound** | **Solvent** | **Sb:Se molar ratio** | **Formation of complex** | **Average film thickness (nm)** | **Band gap (eV)** | **Crystallinity** | **Film quality (surface state)** | **Relative conversion efficiency (to Comparative Example 5)** | **Variation** |
| Example 13 | SbCl₃ | Selenourea | N,N-dimethylformamide | 1:3 | Antimony selenourea, | 120 | 1.30 | Crystalline | Smooth, uniform | 8.9 | OO |
| Example 14 | SbCl₃, | Selenourea | N,N-dimethylformamide | 1:2.1 | Antimony - selenourea | 130 | 1.30 | Crystalline | Smooth, uniform. | 6.4 | O |
| Example 15 | SbCl₃ | Selenourea | N,N-dimethylformamide | 1:4.5 | Antimony - selenourea | 100 | 1.30 | Crystalline | Smooth, uniform | 9.8 | OO |
| Example 16 | SbCl₃ | Selenourea | N,N-dimethylformamide | 1:6 | Antimony - selenourea | 90 | 1.30 | Crystalline | Smooth, uniform | 9.3 | OO |
| Example 17 | SbCl₃ | 1,3-dimethylselenourea | N,N-dimethylformamide | 1:3 | Antimony 1,3-dimethylselen ourea | 110 | 1.30 | Crystalline | Smooth, uniform | 7.4 | OO |
| Comparative Example 5 | SbCl₃, | Sodium selenide | Methanol | 1:3 | None | 120 | 1.30 | Crystalline | Rough, non-uniform | 1.0 | × |
| Comparative Example 6 | SbCl₃ | Selenourea | Water | 1:3 | None | 110 | 1.30 | Crystalline | Rough, non-uniform | 1.1 | × |
| Comparative Example 7 | SbCl₃ | Selenourea | N.N-dimethylformamide | 1:1.5 | Antimony - selenourea | 140 | 1.30 | Crystalline | Smooth, uniform | 3.5 | × |
| Comparative Example 8 | SbCl₃ | Selenourea | N,N-dimethylformamide | 1:12 | Antimony - selenourea | 70 | 1.30 | Crystalline | Smooth, uniform | 2.0 | × |

### INDUSTRIAL APPLICABILITY

The present invention can provide a coating liquid for forming a semiconductor which facilitates large-area production of a semiconductor that is useful as a semiconductor material of a solar cell with high conversion efficiency and small variation in the conversion efficiency. The present invention can also provide a semiconductor thin film produced from the coating liquid for forming a semiconductor, a thin film solar cell, and a method for producing a thin film solar cell.

## Claims

1. A coating liquid for forming a semiconductor, comprising a complex that includes a group 15 metal element of the periodic table and sulfur and/or selenium,
the coating liquid having a molar ratio of the group 15 metal element of the periodic table to the sulfur and/or selenium of 1:2 to 1:10.

2. The coating liquid for forming a semiconductor according to claim 1,
which is prepared from components including at least a metal-containing compound that contains a group 15 metal element of the periodic table, a sulfur-containing compound and/or a selenium-containing compound, and an organic solvent.

3. The coating liquid for forming a semiconductor according to claim 1 or 2,
wherein the group 15 metal element of the periodic table is antimony.

4. A semiconductor thin film produced by applying the coating liquid for forming a semiconductor according to claim 1, 2, or 3 to a substrate.

5. A thin film solar cell comprising a semiconductor prepared from the coating liquid for forming a semiconductor according to claim 1, 2, or 3 as a photoelectric conversion layer.

6. The thin film solar cell according to claim 5,
wherein the photoelectric conversion layer further includes an organic semiconductor adjacent to the semiconductor prepared from the coating liquid for forming a semiconductor according to claim 1, 2, or 3.

7. A method for producing a thin film solar cell, comprising the steps of:
applying the coating liquid for forming a semiconductor according to claim 1, 2, or 3 to a substrate to form a semiconductor thin film; and
laminating an organic semiconductor thin film on the semiconductor thin film.

8. A method for producing a thin film solar cell, comprising the steps of:
laminating an organic semiconductor thin film on a substrate or another layer; and
applying the coating liquid for forming a semiconductor according to claim 1, 2, or 3 to the organic semiconductor thin film to form a semiconductor thin film.

9. A method for producing a thin film solar cell, comprising the step of
applying a mixed liquid of the coating liquid for forming a semiconductor according to claim 1, 2, or 3 and an organic semiconductor to a substrate or another layer.
